# EUROPÄISCHE PATENTANMELDUNG

(11) **EP 1 901 005 A2**
(43) Veröffentlichungstag der Anmeldung: **19.03.2008**
(21) Anmeldenummer: 07016405.8
(22) Anmeldetag: 22.08.2007
(51) Int. Cl.: F24C 7/08, H05B 3/74, H03K 17/97

(54) **Bedienvorrichtung für ein Elektrogerät und Bedienverfahren**

(30) Priorität: 18.09.2006 DE 102006045735
(71) Anmelder: E.G.O. ELEKTRO-GERÄTEBAU GmbH, 75038 Oberderdingen (DE)
(72) Erfinder: Boss, Roland, 75045 Walzbachtal-Jöhlingen (DE)
(74) Vertreter: Patentanwälte Ruff, Wilhelm, Beier, Dauster & Partner

(57) **Zusammenfassung**

Eine Bedienvorrichtung (11) für ein Elektro-Kochfeld weist ein Bedienelement (12) auf zur Durchführung von Bedienfunktionen, das drehbar ist und abnehmbar auf einer Auflage (14) aufliegt. Das Bedienelement (12) ist derart formveränderlich bzw. zusammendrückbar ausgebildet, dass es auf die Auflage (14) gedrückt werden kann. Es nähert sich der Auflage (14) dabei an zur Auslösung einer weiteren Bedienfunktion als Folge des Erkennens dieses Drückens bzw. Annäherns.

## Beschreibung

### Anwendungsgebiet und Stand der Technik

Die Erfindung betrifft eine Bedienvorrichtung für ein Elektrogerät, beispielsweise ein Elektrowärmegerät wie ein Kochfeld, sowie ein Bedienverfahren.

Es ist beispielsweise aus der DE 20 2004 017 133 U1 bekannt, ein externes Bedienelement in Form eines magnetisch gehaltenen Drehknopfes auf einem Kochfeld für eine erste Bedienfunktion, beispielsweise die Auswahl einer Kochstelle, seitlich zu verschieben. Anschließend kann das Bedienelement wieder in seine Ausgangslage zurückgebracht werden, um dann durch Drehen die Leistungshöhe für die ausgewählte Kochstelle zu bestimmen. Ein solches Bedienelement ist dem Grunde nach auch aus der EP 797 227 A1 bekannt.

### Aufgabe und Lösung

Der Erfindung liegt die Aufgabe zugrunde, eine eingangs genannte Bedienvorrichtung sowie ein Bedienverfahren zu schaffen, mit denen erweiterte Bedienfunktionen durch einen neuen Aufbau sowie eine neue Bedienung möglich sind.

Gelöst wird diese Aufgabe durch eine Bedienvorrichtung mit den Merkmalen des Anspruchs 1 sowie durch ein Bedienverfahren mit den Merkmalen des Anspruchs 14. Vorteilhafte sowie bevorzugte Ausgestaltungen der Erfindung sind Gegenstand der weiteren Ansprüche und werden im Folgenden näher erläutert. Der Wortlaut der Ansprüche wird durch ausdrückliche Bezugnahme zum Inhalt der Beschreibung gemacht.

Es ist vorgesehen, dass das Bedienelement bewegbar ist, beispielsweise gedreht und/oder lateral verschoben oder gekippt werden kann für eine Bedienfunktion: Es ist abnehmbar und liegt mit einer Bedienelement-Unterseite auf einer Auflage auf, die vorteilhaft eben und geschlossen ist. Erfindungsgemäß ist das Bedienelement derart formveränderlich bzw. kann derart zusammengedrückt werden, dass es mit seiner Oberseite, insbesondere der gesamten Oberseite, auf die Auflage gedrückt werden kann und sich dieser dabei annähert. Dabei kann nach Erkennen dieses Drückens auf das Bedienelement bzw. des Annäherns dieser Vorgang erkannt werden und eine weitere Bedienfunktion ausgelöst werden. So ist es möglich, dass zusätzlich zu einer Bewegung des gesamten Bedienelementes eine weitere Bedienfunktion durch Drücken auf das Bedienelement bzw. dessen Deformation ausgelöst werden kann. So kann ein Bedienverfahren erweitert bzw. mit zusätzlichen Funktionen versehen werden. Vor allem können mit einem solchen Drücken auf das Bedienelement Bedienfunktionen wie Bestätigen einer möglichen Bedienfunktion oder Aktivieren eines Vorganges intuitiv gemacht werden. Es ist auch möglich, eine Bedienfunktion als Folge eines mehrmaligen Drückens auf das Bedienelement mit jeweiligem Loslassen dazwischen auszugestalten.

Es sind vorteilhaft Erkennungsmittel vorhanden, mit denen die Annäherung der Oberseite des Bedienelementes an die Auflage bzw. das Zusammendrücken des Bedienelementes erkannt werden kann, um daraufhin die zugehörige Bedienfunktion auszulösen. Diese Erkennungsmittel können in dem Bedienelement angeordnet sein, wodurch sie dieses Zusammendrücken direkt und somit sehr sicher und einfach erfassen können. Ein entsprechendes Signal kann dann an eine Steuerung der Bedienvorrichtung weitergegeben werden, beispielsweise unterhalb der Auflage. Alternativ können die Erkennungsmittel oder zumindest deren wesentlicher Teil in der Auflage oder unterhalb der Auflage angeordnet sein, zumindest also nicht am bzw. im Bedienelement. Dies ermöglicht eine einfachere Ausbildung des Bedienelements, weil insbesondere keine elektrischen oder elektronischen Bauteile darin angeordnet sein müssen. Des weiteren ist es in einer weiteren Ausgestaltung der Erfindung möglich, dass die Erkennungsmittel für das Drücken auf das Bedienelement zum Auslösen der weiteren Bedienfunktion dieselben Erkennungsmittel sind, die auch eine andere Bewegung bzw. Bedienung wie Verschieben oder Drehen des Bedienelementes erfassen können. So wird der Bauteilaufwand für die Bedienvorrichtung reduziert.

Vorgenannte Erkennungsmittel können bei Anbringung in dem Bedienelement beispielsweise im Mittelbereich sitzen, ebenso aber auch seitlich. Sind die Erkennungsmittel in oder unter der Auflage angeordnet, so ist es von Vorteil, wenn sie in einem Bereich in etwa entlang des Außenumfangs des Bedienelementes bzw. ein Stück davon nach innen versetzt vorgesehen sind, so dass sie durch das Bedienelement überdeckt werden, zumindest in einer Normal- oder Ruhestellung. Wenn das Bedienelement im wesentlichen für eine Bedienung durch Drehen ausgebildet ist, reicht die Anordnung der Erkennungsmittel in einem entsprechenden kleinen Bereich, wobei sich beispielsweise die Anordnung in einem Kreis anbietet.

Als Erkennungsmittel können Sensoren verwendet werden, die vor allem berührungslos eine Bewegung oder ein Zusammendrücken des Bedienelements erkennen können. Sie können auf Signalgeber reagieren, die in dem Bedienelement angeordnet sind, oder auf das Bedienelement selber ohne zusätzliche Signalgeber. Eine berührungslose Erkennung bzw. Signalübertragung kann beispielsweise kapazitiv oder magnetisch erfolgen. Bei einer magnetischen Signalübertragung bietet es sich an, die Sensoren als Hall-Sensoren auszubilden. Signalgeber in dem Bedienelement können dann entsprechende Magnete sein. Derartige Erkennungsmittel eignen sich nicht nur für das Erkennen von einem Zusammendrücken des Bedienelementes, sondern auch von dessen Bewegung bzw. Drehung.

Die Formveränderlichkeit des Bedienelementes kann so sein, dass seine gesamte obere Seite bzw. sein gesamtes Oberteil eingedrückt bzw. nach unten zusammengedrückt werden kann auf die Auflage zu. Dabei werden Oberseite und Unterseite des Bedienelements zusammengedrückt bzw. bewegen sich aufeinander zu. Es wird also nicht nur ein Bereich des Oberteils oder der Oberseite eingedrückt, beispielsweise nach Art eines Knopfes, sondern es erfolgt ein großflächiges Ein- oder Herunterdrücken. Ist das Bedienelement beispielsweise in eine obere und eine untere Hälfte aufgeteilt oder unterteilbar, so kann eine starre obere Hälfte gegen eine formveränderliche untere Hälfte gedrückt werden.

Eine Ausgestaltung einer Formveränderlichkeit kann elastisches oder biegbares Material vorsehen, beispielsweise einen elastischen Kunststoff. Dieses elastische oder biegbare Material ist besonders vorteilhaft im unteren Bereich des Bedienelements vorgesehen bzw. kann dessen Unterseite bilden.

In einer anderen Ausgestaltung der Erfindung kann die Formveränderlichkeit des Bedienelements durch eine elastische Membran bzw. dadurch erreicht werden, dass die Bedienelement-Unterseite mit einer dünnen Wandung oder dünn ausgebildet ist. Das von ihr begrenzte Volumen kann bei Druck auf das Bedienelement von oben komprimiert werden.

In einer nochmals anderen Ausgestaltung der Erfindung kann die Unterseite des Bedienelements kompressibel ausgebildet sein bzw. entsprechendes Material aufweisen. Dies kann beispielsweise ein relativ weicher Gummi sein, beispielsweise als Vollmaterial. Ein derartiges kompressibles Material kann auch in Schichtform vorgesehen sein.

In nochmals anderer Ausgestaltung der Erfindung kann ein Teil des Bedienelements, insbesondere die Unterseite, gelenkig ausgebildet sein bzw. es können gelenkige Bereiche daran angeordnet sein. Hierbei ersetzen die Gelenke das vorgenannte elastische oder biegbare Material.

Vorteilhaft ist vorgesehen, dass das Bedienelement nicht nur zusammengedrückt werden kann, sondern sich nach Nachlassen des Drucks auch wieder selbsttätig zurückstellt. Hierfür kann eine Rückstelleinrichtung vorgesehen sein, die eine Rückstellkraft erzeugt, welche das Bedienelement eben zurückbewegt bzw. die Oberseite wieder von der Auflage wegdrückt. Eine solche Rückstelleinrichtung ist vorteilhaft innerhalb des Bedienelements zwischen Unterseite und Oberseite vorgesehen.

Gemäß einer Ausgestaltung der Erfindung kann eine Rückstelleinrichtung mit Federkraft arbeiten bzw. eine Feder aufweisen, beispielsweise als flache Tellerfeder oder mindestens eine Schraubenfeder. Vorteilhaft können auch Kunststofffedern verwendet werden, insbesondere auch aus massiven elastischen Kunststoffkörpern wie Schaumstoff odgl..

Gemäß einer alternativen Ausgestaltung der Erfindung kann eine Rückstelleinrichtung magnetisch arbeiten bzw. Magnete aufweisen. Dazu können zwischen der Oberseite und der Unterseite des Bedienelements gleichsinnig gepolte Magnete angeordnet sein. Bei einem Druck auf die Oberseite des Bedienelements nähern sie sich einander an, unter Umständen liegen sie sogar aneinander an. Bei Nachgeben des Druckes stoßen sie sich wieder ab, so dass das Bedienelement in seine ursprüngliche Form zurückkehrt. Zur Unterbringung der Magnete kann das Bedienelement innen hohl sein. Es ist auch von Vorteil, wenn sich das gesamte Bedienelement beim Zusammendrücken in seinem Volumen ändert bzw. verkleinert.

Es ist möglich, dass das Bedienelement magnetisch an der Auflagefläche gehalten bzw. bei einer Drehbewegung als Bedienbewegung zentriert wird. Dazu können in dem Bedienelement und korrespondierend unter der Auflagefläche Magnete angeordnet sein, vorzugsweise in der Mitte des Bedienelements.

Von Vorteil ist es, wenn das Bedienelement nach außen geschlossen bzw. abgedichtet ist. So kann weder Schmutz noch Flüssigkeit hineingelangen und dieses entweder hygienisch verschmutzen oder aber seine Funktion beeinträchtigen, insbesondere hinsichtlich eines möglichen Zusammendrückens. Die Auflage für das Bedienelement kann ohne Durchbruch bzw. geschlossen ausgebildet sein. Dies ist vor allem bei einer Kochfeldplatte eines Kochfeldes von Bedeutung.

Der Weg, um den das Bedienelement zum Auslösen der Bedienfunktion zusammengedrückt werden kann, kann im Bereich von unter 1mm bis zu wenigen mm liegen. Es ist von Vorteil, wenn der Bedienweg so groß ist, dass eine Bedienperson das Herunterdrücken des Oberteils deutlich spürt, so dass eine haptische Rückkopplung erfolgt. Hierbei kann auch ein kleiner Rastwiderstand odgl. vorgesehen sein, der sozusagen einen Schaltpunkt definiert.

Ein erfindungsgemäßes Bedienverfahren kann vorsehen, dass durch das Drücken auf das Bedienelement voreingestellte Optionen ausgewählt bzw. bestätigt werden. Es kann bei einem Bedienverfahren vorgesehen sein, das Drücken und Loslassen des Bedienelementes allein als Bedienfunktion vorzusehen. Es kann bei einem Bedienverfahren vorgesehen sein, das Drücken und Loslassen des Bedienelementes allein als Bedienfunktion vorzusehen. Alternativ kann vorgesehen sein, ein Bewegen oder Drehen des Bedienelementes unter Druck vorzunehmen, welches dann eine andere Bedienfunktion auslöst als ein Bewegen des Bedienelementes ohne Druck darauf oder lediglich der Druck auf das Bedienelement, ohne es zu bewegen. Es kann also beispielsweise durch Drehen oder Bewegen des Bedienelementes eine bestimmte Funktion oder Option ausgewählt oder vorgeschlagen werden. Durch Drücken auf das Bedienelement findet dann die endgültige Auswahl und Übernahme als Bedienfunktion statt. Anschließend kann eine weitere Auswahl durch Bewegen des Bedienelementes erfolgen usw..

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombination bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränken die unter diesen gemachten Aussagen nicht in ihrer Allgemeingültigkeit.

### Kurzbeschreibung der Zeichnungen

Ausführungsbeispiele der Erfindung sind in den Zeichnungen schematisch dargestellt und werden im Folgenden näher erläutert. In den Zeichnungen zeigen:
- Fig. 1: eine geschnittene Schrägansicht einer ersten Ausführungsform einer erfindungsgemäßen Bedienvorrichtung;
- Fig. 2 und 3: schematisierte Darstellungen von Anordnungen von Magneten und Magnetfeldsensoren bei einem Bedienelement ähnlich Fig. 1 und
- Fig. 4: eine weitere mögliche Ausführung eines Bedienelements mit einem unteren Bereich aus kompressiblem Material.

### Detaillierte Beschreibung der Ausführungsbeispiele

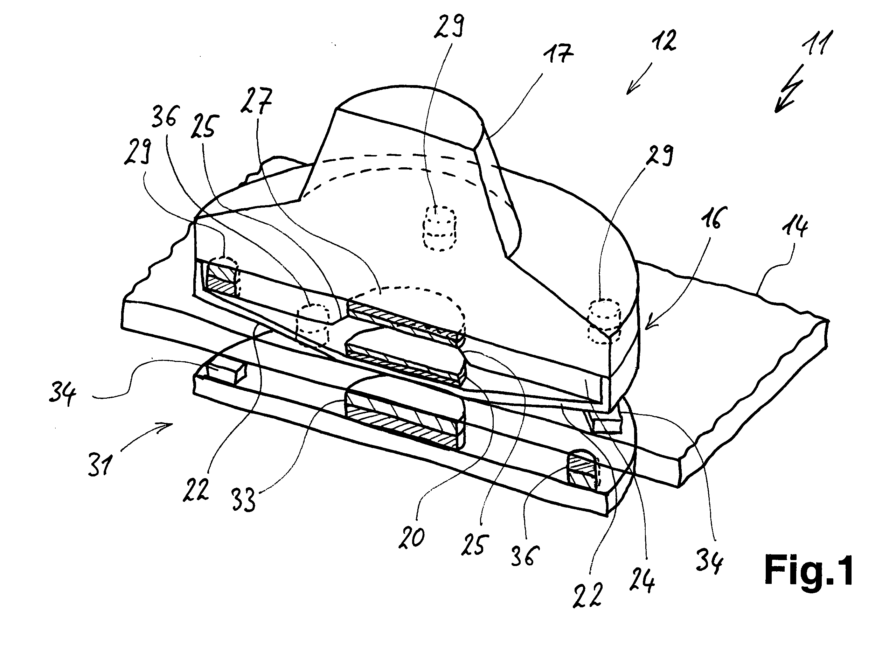

In Fig. 1 ist eine geschnittene Schrägansicht auf eine erfindungsgemäße Bedienvorrichtung 11 dargestellt mit einem Bedienelement 12, das abnehmbar auf einer Auflage 14 sitzt. Die Auflage 14 kann beispielsweise eine Kochfeldplatte eines Glaskeramik-Kochfeldes sein, ebenso eine sonstige Blende oder Wand eines Elektrogerätes.

In dem Bedienelement 12 ist in einem unteren breiteren Basisteil 16, das nach oben zu in einen schmaleren Drehteil 17 übergeht, die wesentliche Funktionalität des Bedienelements 12 enthalten. Dies ist zum einen ein unterer Zentralmagnet 20 in Form einer flachen Rundscheibe. Der untere Zentralmagnet 20 sitzt auf einer Membran 22 auf, die zwar relativ widerstandsfähig ausgebildet sein kann, jedoch elastisch genug ist, dass sie sich durch Herunterdrücken des Bedienelements 12 verformen kann. Dabei liegt dann im verformten Zustand die Membran 22 gegen eine Innenscheibe 24 an, die den unteren Bereich des Basisteils 16 über der Membran bildet. Die Innenscheibe 24 wiederum kann aus festem Kunststoff odgl. bestehen. Sie weist im mittleren Bereich eine Innenausnehmung 25 auf, die so ausgebildet ist, dass darin der untere Zentralmagnet 20 so aufgenommen wird, dass die Innenscheibe 24 direkt auf der Membran 22 aufliegt, welche wiederum gegen Auflage 14 gedrückt ist.

An der Innenausnehmung 25 bzw. relativ genau oberhalb des unteren Zentralmagneten 20 befindet sich ein oberer Zentralmagnet 27. Er kann im wesentlichen gleich groß ausgebildet sein wie der untere Zentralmagnet 20, allerdings ist er so angeordnet, dass er gleichsinnig gepolt ist. Dadurch stoßen sich die beiden Zentralmagneten 20 und 27 ab. Dies wird nachfolgend noch näher erläutert.

Die Membran 22 geht von dem flachen unteren Bereich unterhalb des unteren Zentralmagneten 20 schräg nach oben nach außen und dann in einen breiten Rand über, der wiederum in den Außenrand des Basisteils 16 übergeht bzw. diesen mitbildet. An der Unterseite des Basisteils 16 befindet sich die vorgenannte Innenscheibe 24 mit der Innenausnehmung 25 und dem oberen Zentralmagneten 27 darin. Des weiteren ist in dieser Innenscheibe 24 noch eine Anzahl von Signalmagneten 29 vorgesehen, und zwar beispielhaft sechs Stück. Diese sitzen in der Innenscheibe 24, wobei sie beispielsweise, ähnlich wie der obere Zentralmagnet 27, darin eingespritzt bzw. befestigt sein können. Alternativ können sie in entsprechende Ausnehmungen hineingesteckt und beispielsweise festgeklebt werden. Der sonstige, oberhalb der Innenscheibe 24 und der Membran 22 befindliche Teil des Bedienelements 12, insbesondere auch der Drehteil 17, können ebenfalls aus Kunststoff gefertigt sein, beispielsweise in einem einzigen Stück.

Unterhalb der Auflage 14 befindet sich eine Gegenplatte 31. Diese trägt einen Haltemagnet 33, der genau unterhalb der beiden Zentralmagneten 20 und 27 sitzt und dabei von der Polung her dem unteren Zentralmagnet 20 entgegengesetzt ist, so dass sich die beiden Magnete anziehen. Der Haltemagnet 33 dient, wie dies an sich aus dem eingangs genannten Stand der Technik bekannt ist, zur Halterung des Bedienelements 12 an der Auflage 14. Des weiteren bildet er sozusagen eine Drehachse, so dass das Bedienelement 12 beim Drehen normalerweise seitlich nicht verrutscht. Die Gegenplatte 31 kann wiederum aus Kunststoff bestehen und der Haltemagnet 33 kann aufgesetzt sein. Alternativ kann er zum Teil oder ganz darin versenkt sein, beispielsweise auch eingegossen oder eingespritzt. Die Gegenplatte 31 kann auch eine Leiterplatte mit elektrischen bzw. elektronischen Bauteilen sein, beispielsweise auch einer Steuerung.

Um den Haltemagnet 33 herum befindet sich mit gleichem Abstand wie die oberen Signalmagnete 29 zu den Zentralmagneten 20 und 27 herum Hall-Sensoren 34 zur Erfassung von Magnetfeldänderungen. Es können zwei Stück sein gemäß Fig. 1, unter Umständen auch mehr. Diese Hall-Sensoren 34 registrieren die Veränderungen des Magnetfeldes, wenn sich die Signalmagnete 29 bei einer Drehung des Bedienelements 12 von ihnen entfernen bzw. sich ihnen nähern. Daraus kann ein zurückgelegter Drehwinkel bestimmt werden, wie dies allerdings auch bereits aus dem Stand der Technik bekannt ist. Des weiteren trägt die Gegenplatte 31 Rastmagnete 36 auf dem selben Kreis bzw. mit demselben Abstand zu dem Haltemagnet 33. Diese Rastmagnete 36 wirken mit den Signalmagneten 29 derart zusammen, dass sie sich aufgrund der gleichsinnigen Polung abstoßen. Während die Abstoßung zwischen den Zentralmagneten 20 und 27 den oberen Teil des Bedienelements 12 von der Auflage 14 weg nach oben drückt, gilt dies für die Signalmagnete 29 und Rastmagnete 36 nur zum Teil auch. Des weiteren stoßen sie sich aber vor allem bei einer Drehung in Umfangsrichtung so ab, dass der zu überwindende Widerstand umso größer wird, je näher während der Drehung ein Signalmagnet 29 einem Rastmagneten 36 kommt. So kann eine magnetische Rastung als haptische Rückwirkung an eine Bedienperson erzeugt werden, was jedoch ebenfalls aus dem Stand der Technik grundsätzlich bekannt ist. Anstelle der hier dargestellten jeweils sechs Signalmagnete 29 und Hall-Sensoren 34 sowie Rastmagneten 36 können auch beliebig andere Anzahlen davon verwendet werden.

### Funktion

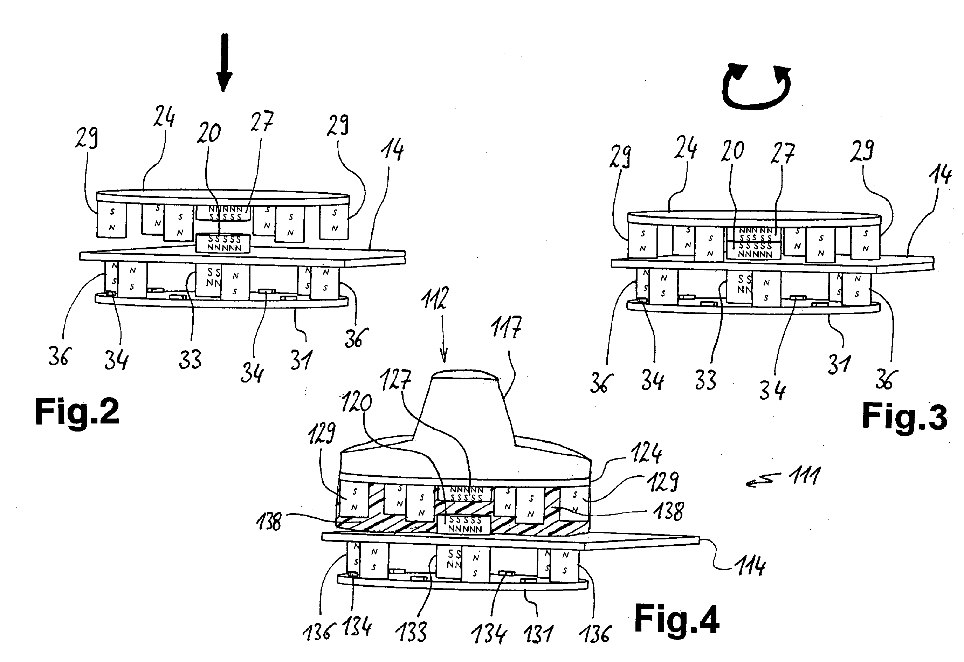

Die Funktion einer Bedienvorrichtung 11 gemäß Fig. 1 wird anhand der Fig. 2 und 3 zusätzlich erläutert. Dabei sind in den Fig. 2 und 3 in schematischer, vereinfachter Darstellung lediglich die Magnete, die Hall-Sensoren 34 und die obere Innenscheibe 24 und die Gegenplatte 31 dargestellt an einer Auflage 14.

In Fig. 2 befinden sich die Zentralmagnete 20 und 27 auseinander. Dieses Auseinanderdrücken kann neben der magnetischen abstoßenden Kraft auch durch die druckfederartigen Eigenschaften der Membran 22 begünstigt werden, so dass sozusagen zwei Kräfte den oberen Teil des Bedienelements 12 wieder nach oben drücken, weg von der Auflage 14. Das Bedienelement 12 im entspannten Zustand gemäß Fig. 2 kann gedreht werden für eine Bedienung. Diese Drehung kann an den Hall-Sensoren 34 erkannt werden, da sich dort die Signalmagnete 29 vorbeibewegen und somit an den Hall-Sensoren eine sich ändernde Feldstärke vorliegt. Die Zentrierung bzw. Halterung des Bedienelements 12 an der Auflage 14 erfolgt durch den unteren Zentralmagneten 20, der von dem Haltemagnet 33 gehalten wird. Die eingezeichneten Polungen sind nur beispielhaft und können sinngemäß auch gedreht sein. Die Polung der Positions- und Rastmagnete relativ zur Polarität der Haltemagnete ist in der Darstellung ebenfalls beispielhaft, d.h. sie kann auch umgekehrt sein.

Wird nun das Bedienelement 12 zusammengedrückt bzw. der Drehteil 17 auf die Auflage 14 zu bewegt, so ergibt sich die in Fig. 3 dargestellte schematische Konfiguration. Das Bedienelement 12 wird dabei soweit zusammengedrückt, dass die beiden Zentralmagneten 20 und 27 aufeinander aufliegen. Es muss jedoch nicht unbedingt so weit sein. Hierbei kommen auch die Signalmagnete 29 der Auflage 14 näher, beispielsweise soweit, bis sie direkt gegen die Membran 22 drücken, welche wiederum direkt gegen die Auflage 14 drückt. Eine Erkennung des Drehens des Bedienelements 12 erfolgt wiederum genauso wie vorher beschrieben, also durch eine sich ändernde, initial abnehmende magnetische Feldstärke an den Hall-Sensoren 34. Des weiteren kann jedoch an den Hall-Sensoren auch insgesamt erkannt werden, dass das Magnetfeld stärker ist als bei der Konfiguration gemäß Fig. 2, da hier die Signalmagnete 29 ein deutliches Stück näher sind. Da sich diese Änderung bei einem gesamten Herunterdrücken des Bedienelements 12 an allen Hall-Sensoren 34 zeigt, kann dies von einer nicht dargestellten, mit den Sensoren verbundenen Steuerung auch problemlos erkannt werden. Auf ähnliche Weise kann auch erkannt werden, wenn der Druck auf das Bedienelement 12 nachgelassen wird, so dass sich dieses wieder nach oben bewegt und die magnetische Feldstärke an den Hall-Sensoren 34 wieder schwächer wird. Es kann also während der ganzen Zeit eine Drehbewegung ausgewertet werden, ebenso das Drücken und das Loslassen. Eine Drehbewegung mit heruntergedrücktem Bedienelement 12 kann eine andere Betätigung darstellen bzw. Funktion auslösen als eine normale Drehbewegung.

Gemäß einer nicht dargestellten Bedienung kann das Bedienelement 12 auch sozusagen seitlich gekippt werden bzw. nur an einer Seite heruntergedrückt werden, also ähnlich wie ein Joystick verkippt werden. Dann nähert sich die Innenscheibe 24 mit den Signalmagneten 29 nicht gleichmäßig dem unteren Teil an vor allem an einer Seite. Auch dies kann an den Hall-Sensoren 34 erkannt werden, da dann eigentlich nur an einem oder unter Umständen auch zwei Hall-Sensoren eine einigermaßen deutliche Änderung der Feldstärke als Zunahme bei gleichzeitiger gegenphasiger Änderung auf der gegenüberliegenden Seite erkannt werden kann. Ein solches Verkippen des Bedienelements 12 ist vorteilhaft als einzelne Bedienung ohne Drehung vorgesehen, ähnlich wie das Drücken auf eine Taste. So wird das Bedienelement 12 erst verkippt für eine dementsprechende Bedienfunktion, und kehrt dann wieder in seine Ausgangslage zurück, und kann anschließend entweder wieder insgesamt nach unten gedrückt oder gedreht werden.

In Fig. 4 ist insofern, aufbauend auf den schematischen Darstellungen gemäß der Fig. 2 und 3, eine Abwandlung dargestellt, als hier keine flexible Membran 22 gemäß Fig. 1 vorgesehen ist, sondern der Bereich unter der Innenscheibe 124 großteils mit elastischem und kompressiblem Material ausgefüllt ist, beispielsweise Schaumstoff. Dafür sind zwei Möglichkeiten vorstellbar. Gemäß einer ersten Möglichkeit erfolgt ein vollständiges Ausspritzen des unteren Bereichs mit diesem Schaumstoff, so dass die Magnete des Bedienelements 112 vollständig darin eingebettet sind. Somit befindet sich auch zwischen den Signalmagneten 129 und der Auflage 114 sowie zwischen dem oberen Zentralmagnet 127 und dem unteren Zentralmagnet 120 der Schaumstoff 138. Dieser Schaumstoff 138 weist üblicherweise eine so große Eigenelastizität auf, dass diese ausreicht, das Bedienelement nach Entlasten des Drucks von der zusammengedrückten Form wieder auseinander zu drücken in die Ausgangsform. Dabei kann unter Umständen sogar auf den oberen Zentralmagneten 127 verzichtet werden, der nur dazu da ist, um mit seiner abstoßenden Kraft zum unteren Zentralmagneten 120 das Bedienelement wieder auseinander zu drücken.

In alternativer Ausgestaltung könnten unterhalb der Signalmagnete 129 und zwischen den Zentralmagneten 120 und 127 Ausnehmungen im Schaumstoff 138 vorgesehen sein für die Magnete. Dann kann das Bedienelement 112 weiter auf die Auflage 114 zu gedrückt werden, was einer Signalerkennung an den Hall-Sensoren 134 zugute kommt. Des weiteren könnte der Verschleiß des Schaumstoffmaterials 138 gesenkt werden.

Die äußere Oberfläche des Schaumstoffs 138 kann für eine stärkere mechanische Belastbarkeit beschichtet bzw. umhüllt sein, beispielsweise mit einer widerstandsfähigen, elastischen Gummischicht odgl..

Als weitere Alternative zu den Zentralmagneten oder dem Schaumstoff kann eine Schraubenfeder eingesetzt werden in ein Bedienelement ähnlich Fig. 1, beispielsweise an die Stelle des oberen Zentralmagneten oder mehrere Schraubenfedern oder Kunststofffedern zwischen den Signalmagneten außen.

## Patentansprüche

1. Bedienvorrichtung (11 111) für ein Elektrogerät, vorzugsweise für ein Elektrowärmegerät wie ein Kochfeld, wobei die Bedienvorrichtung (11, 111) ein Bedienelement (12, 112) aufweist zur Durchführung von Bedienfunktionen, das bewegbar ist und abnehmbar mit einer Bedienelement-Unterseite auf einer Auflage (14, 114) aufliegt, **dadurch gekennzeichnet, dass** das Bedienelement (12, 112) derart formveränderlich bzw. zusammendrückbar ausgebildet ist, dass es mit seiner Oberseite (17, 117) auf die Auflage (14, 114) zu gedrückt werden kann und sich dieser dabei annähert zur Auslösung einer weiteren Bedienfunktion als Folge des Erkennens dieses Drückens bzw. Annäherns.

2. Bedienvorrichtung nach Anspruch 1, **dadurch gekennzeichnet, dass** die Annäherung der Oberseite (17, 117) des Bedienelements (12, 112) bzw. das Zusammendrücken des Bedienelements (12, 112) durch Erkennungsmittel (29, 34, 129, 134) erkennbar ist zum Auslösen der weiteren Bedienfunktion, wobei vorzugsweise die Erkennungsmittel (34, 134) zumindest teilweise unterhalb der Auflage (14, 114) angeordnet sind.

3. Bedienvorrichtung nach Anspruch 1 oder 2, **dadurch gekennzeichnet, dass** das Herunterdrücken der Oberseite (17, 117) des Bedienelements (12, 112) bzw. das Zusammendrücken des Bedienelements (12, 112) durch dieselben Erkennungsmittel (34, 134) für die weitere Bedienfunktion erkennbar ist wie für andere Bedienungen bzw. andere Bedienfunktionen.

4. Bedienvorrichtung nach einem der vorhergehenden Ansprüche, **dadurch gekennzeichnet, dass** die Erkennungsmittel Sensoren (34, 134) sind, die unter dem Bedienelement (12, 112) angeordnet sind und auf Signalgeber (29, 129) odgl. In dem Bedienelement (12, 112) reagieren, wobei insbesondere die Sensoren magnetische Hall-Sensoren (34, 134) sind und die Signalgeber in dem Bedienelement (12, 112) Magnete (29, 129) sind.

5. Bedienvorrichtung nach einem der vorhergehenden Ansprüche, **dadurch gekennzeichnet, dass** das Bedienelement (12, 112) derart formveränderlich ist, dass sein gesamtes Oberteil (17, 117) eingedrückt bzw. auf die Auflage (14, 114) zu und damit gegen die Unterseite des Bedienelements (12, 112) gedrückt werden kann.

6. Bedienvorrichtung nach Anspruch 5, **gekennzeichnet durch** elastisches oder biegbares Material (22, 138) am Bedienelement (12, 112) für die Formveränderlichkeit, vorzugsweise einen elastischen Kunststoff, wobei insbesondere das elastische oder biegbare Material (22, 138) im unteren Bereich (16, 116) des Bedienelements (12, 112) vorgesehen ist.

7. Bedienvorrichtung nach Anspruch 6, **dadurch gekennzeichnet, dass** die Bedienelement-Unterseite als elastische Membran (22) bzw. dünne Wandung ausgebildet ist, wobei das von ihr begrenzte Volumen durch Druck auf die Oberseite des Bedienelements (12) komprimierbar ist zum Zusammendrücken des Bedienelements (12) bzw. zur Annäherung an die Auflage (14).

8. Bedienvorrichtung nach Anspruch 5, **gekennzeichnet durch** eine Formveränderlichkeit des Bedienelements (112) **durch** eine kompressible Ausbildung des Bedienelement-Unterteils (116), insbesondere in flacher Form oder Schichtform, wobei vorzugsweise kompressibles Material in Form von Gummi oder Schaumstoff (138) vorgesehen ist.

9. Bedienvorrichtung nach einem der vorhergehenden Ansprüche, **gekennzeichnet durch** eine Rückstelleinrichtung (20, 27, 120, 127, 138) zur Erzeugung einer Rückstellkraft zum Zurückbewegen des Bedienelements (12, 112) bzw. der Oberseite (7, 117) des Bedienelements (12, 112) weg von der Auflage (14, 114), wobei vorzugsweise die Rückstelleinrichtung (20, 27, 120, 127, 138) zwischen Bedienelement-Unterseite und Oberseite des Bedienelements (12, 112) angeordnet ist derart, dass das Bedienelement bei Druck zusammengedrückt ist und bei Nachgeben des Drucks **durch** die Rückstellkraft in seine ursprüngliche Form bzw. Lage zurückkehrt.

10. Bedienvorrichtung nach Anspruch 9, **dadurch gekennzeichnet, dass** die Rückstelleinrichtung mit Federkraft arbeitet bzw. eine Federeinrichtung (22, 138) aufweist.

11. Bedienvorrichtung nach Anspruch 9, **dadurch gekennzeichnet, dass** die Rückstelleinrichtung mit Magnetkraft arbeitet bzw. Magnete aufweist, wobei vorzugsweise zwischen Bedienelement-Unterseite und Oberseite des Bedienelements (12, 112) zwei gegensätzlich gepolte Magnete (20, 27, 120, 127) angeordnet sind, die sich bei Druck auf die Oberseite des Bedienelements (12, 112) aneinander annähern oder anliegen und sich bei Nachgeben des Drucks abstoßen zur Rückkehr des Bedienelements (12, 112) in seine ursprüngliche Form bzw. Lage.

12. Bedienvorrichtung nach einem der vorhergehenden Ansprüche, **dadurch gekennzeichnet, dass** das Bedienelement (12, 112) nach außen geschlossen bzw. abgedichtet ist, insbesondere flüssigkeitsdicht.

13. Bedienvorrichtung nach einem der vorhergehenden Ansprüche, **dadurch gekennzeichnet, dass** die Auflage (14, 114) undurchbrochen bzw. geschlossen ist, wobei sie vorzugsweise eine Kochfeldplatte eines Kochfelds ist.

14. Bedienverfahren für eine Bedienvorrichtung nach einem der vorhergehenden Ansprüche, **dadurch gekennzeichnet, dass** durch das Drücken auf das Bedienelement (12, 112) voreingestellte Optionen ausgewählt bzw. bestätigt werden.

15. Bedienverfahren nach Anspruch 14, **dadurch gekennzeichnet, dass** ein Bewegen oder Drehen des Bedienelements (12, 112) unter Druck eine andere Bedienfunktion auslöst als ein Bewegen des Bedienelements (12, 112) ohne Druck darauf oder lediglich der Druck auf das Bedienelement ohne Bewegen.

16. Bedienverfahren nach einem der Ansprüche 14 bis 15, **dadurch gekennzeichnet, dass** durch Drehen oder Bewegen des Bedienelements (12, 112) eine bestimmte Funktion oder Option ausgewählt oder vorgeschlagen wird und durch Drücken auf das Bedienelement (12, 112) dann die endgültige Auswahl und Übernahme als Bedienfunktion stattfindet, wobei vorzugsweise anschließend eine weitere Auswahl durch Bewegen des Bedienelements (12, 112) erfolgt.
